## Europäisches Patentamt
## European Patent Office
## Office européen des brevets

(11) Publication number: **0 083 699**
**A2**

(12) # EUROPEAN PATENT APPLICATION

(21) Application number: **82109890.2**

(22) Date of filing: **26.10.82**

(51) Int. Cl.³: **H 01 L 27/02**

(30) Priority: **11.01.82 US 338388**

(43) Date of publication of application:
**20.07.83 Bulletin 83/29**

(84) Designated Contracting States:
**DE FR GB**

(71) Applicant: **International Business Machines Corporation**
**Old Orchard Road**
**Armonk, N.Y. 10504(US)**

(72) Inventor: **Cook, Herbert Carl**
**RFD No. 2**
**Milton, Vt 05468(US)**

(72) Inventor: **Grise, Gary Douglas**
**Rd. No. 1, Claypoint Road**
**Milton, Vt 05468(US)**

(72) Inventor: **Lam, Chung Hon**
**23 Hillside Drive**
**Williston, Vt 05495(US)**

(74) Representative: **Barth, Carl Otto, Dipl.-Ing. et al,**
**IBM Europäische Patentdienste Rablstrasse 24**
**D-8000 München 80(DE)**

(54) **Protective circuit for semiconductor devices.**

(57) An input pad overvoltage protective circuit for integrated devices is disclosed. It enables both positive and negative polarity input signals be applied to a protected gate (14) of an FET (11). The protective circuit comprises a first resistor (12) coupled between an input pad (13) and the gate (14) and a current limiting second resistor (15) and diode (16) coupled between the pad and a reference potential.

FIG. 1

EP 0 083 699 A2

0083699

## PROTECTIVE CIRCUIT FOR SEMICONDUCTOR DEVISES

This invention relates generally to semiconductor devices and circuits and more particularly to a protective device for preventing breakdown or rupture of the gate oxide of a memory circuits such as a read only memory.

Protective current limiting circuits and diodes for insulated gate field effect transistors are known in the art. For example, the article "Gate Protection of MIS Devices", M. Lenzlinger, IEEE Tr. on Electron Devices, ED-18, #4, April 1971, pgs. 249-257, is of interest as it describes various gate protection aspects in which protection against both positive and negative input signals requires a pair of back-to-back diodes.

H. Iizuka et al, in an article entitled, "Electrically Alterable Avalanche-Injection-Type MOS Read Only Memory with Stacked-Gate Structure", appearing in the IEEE Tr. Electron Devices, ED-23, #4, April 1976, pgs. 379-387, teaches a resistor protective control N gate input circuit in which a first resistor is in series between the input and the control gate and a second resistor couples the control gate to the substrate.

U.S. Patent 3 590 340 to M. Kubo et al, teaches the use of a resistor between a protect diode and a protect gate to provide a delay so that the protect diode is insured of operation before the high level input signal can reach the gate oxide breakdown voltage.

U.S. Patent 4 011 467 to S. Shimada et al, teaches an input protection circuit for a ground clamped input pad in which two resistors and a diode coupled depletion device are used.

BU 981 010

The article, "Protective Device for LSI FET Circuits", N. Edwards, IBM TDB, Vol. 22, #6, November 1979, pg. 2326, teaches that resistors can be used as input protection circuits and may be formed of polysilicon.

This prior art does not show an input protection circuit of simple design which can be used in circuits to which working input signals of positive and negative polarity are applied.

The present invention intends to overcome this drawbacks by giving a protection circuit which not only permits negative control input signals to be applied but also protects against excessively large positive and negative signals.

The invention is particularly directed toward an input over voltage protection circuit for the control lines of an electronically erasable, programmable read only memory, EEPROM.

This protection circuit can be tailored to permit the application of both positive and negative voltages to the gate electrode of the EEPROM, but is independent of the process and circuit specifications of the circuit to be protected.

The protective circuit of this invention is designed to permit both positive and negative voltages to be applied to the protected device without increasing appreciably the area of the device produced since one of the resistors is produced beneath the input pad.

According to the preferred embodiment, the protect circuit includes a first branch in which the input pad is connected to the control gates of the device to be pro-

BU 981 010

tected through a current limiting resistor and a second branch in which the input pad is connected through another current limiting resistor and a diode to ground so that, if positive or negative input signals greater than the breakdown voltage of the protect diode are applied, the diode will break down and clamp the pad and prevent the control gate voltage from exceeding the voltage at which destructive gate oxide breakdown occurs.

Thus the invention provides an input pad protect circuit for an integrated circuit chip which enables both positive and negative polarity input signals to be applied to the gate of an FET device.

In summary there is described an input overvoltage protection circuit for gated circuits such as MIS integrated circuits comprising a signal input chip pad coupled to the gate of the insulated semiconductor device to be protected by a circuit comprising a first thin film current limiting resistor in series with a diode and coupled between the input pad and the source of reference potential and a second thin film current limiting resistor in series with the pad and the gate of the device being protected.

Thus, permitting both positive and negative voltage signals to be applied to the protected device.

Other objects and features of the invention will be more fully appreciated from the following specification taken in conjunction with the appended drawings in which

Fig. 1    shows a schematic representation of the protect circuit of the invention.

BU 981 010

Fig. 2    shows a plan view of the device as actually produced on a semiconductor surface.

Fig. 3    illustrates a section of the device of Fig. 1 taken along the lines 3-3.

Fig. 4    is a graph of current vs. voltage for the gated device of Fig. 1.

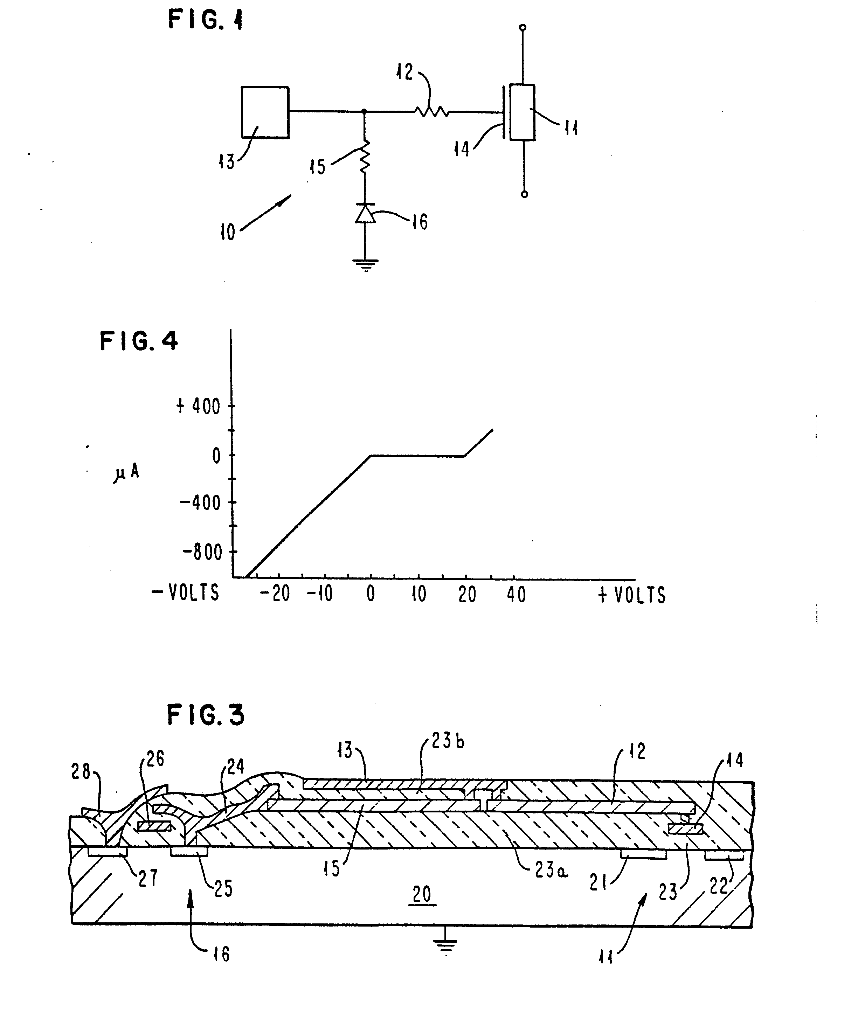

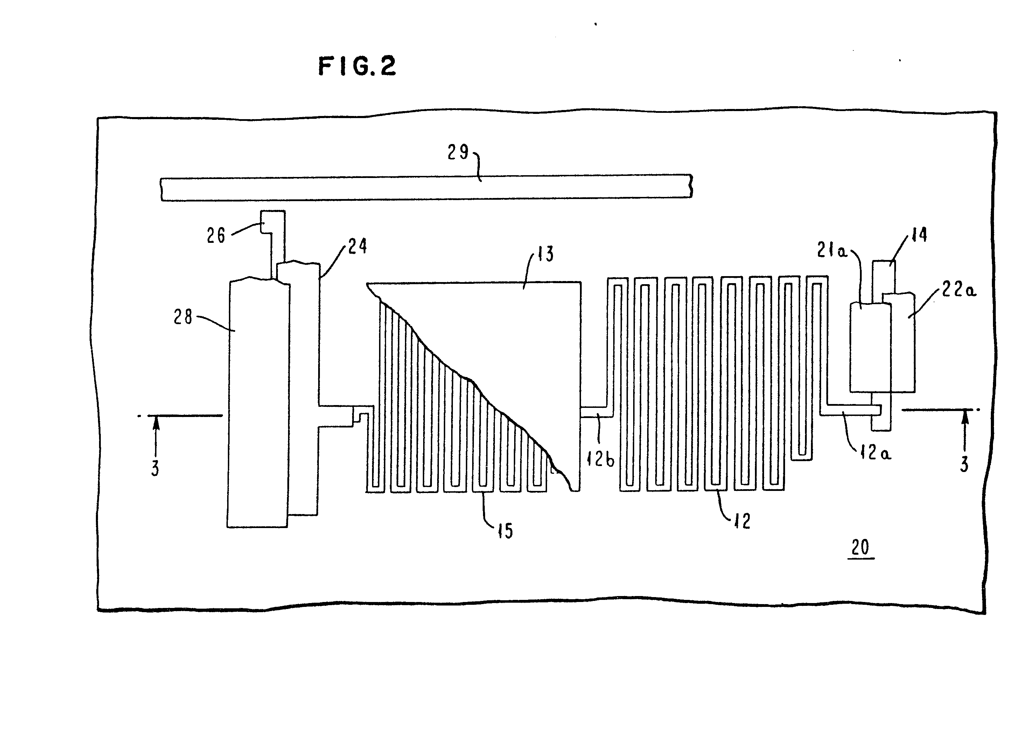

Fig. 1 shows the present invention in schematic form as a circuit 10, for protecting the gate of a field effect transistor (FET) 11, comprising a first resistor 12 coupling a voltage input pad 13 to the gate 14 of the FET 11 and a series circuit, comprising a second resistor 15 coupled to the cathode of a protect diode 16, coupled between the pad 13 and ground. This overvoltage protective circuit 10 is preferably used in conjunction with an electrically erasable, programmable read only memory (EEPROM). In such EEPROMs it is necessary at times to input both large negative voltages and large positive voltages on the gate electrode. Larger positive or negative voltages can cause the gate oxide to break down. This circuit permits the voltage applied to the pad 13 to have both large positive and negative excursions while still providing input overvoltage, positive and negative, protection to the gate electrode.

When such EEPROM circuits are formed in integrated circuits, as will be described below, the diode 16 must be designed to have a reverse breakdown voltage smaller than the breakdown voltage of the gate oxide layer being protected. Also, the resistance value of the resistors 12 and 15 must be carefully designed such that the RC time constant obtained with resistor 12 and the wiring and gate capacitance of gate 14 is long enough to insure full static discharge through the reversed biased diode 16 and the resistor 15 before the gate 14 receives any damaging positive potentials. It must also be considered that, when negative voltages are applied to the pad 13, the diode 16 is forward biased. Thus the resistor 15 must be sufficient to limit the current from ground to pad 13, i. e. this limits power consumption of the circuit in these negative voltage conditions.

Fig. 2 shows a topographical layout of an integrated circuit built in accordance with the present invention, while Fig. 3 illustrates a cross-sectional view of the circuit shown in Fig. 2 taken along the lines 3-3. Figs. 2 and 3 show the protective circuit of Fig. 1 fabricated to protect the FET 11 formed in a grounded semiconductor substrate 20 of a first conductivity type, i. e. P+ type, silicon. The source and drain regions 21 and 22 of the FET 11 are formed by diffusion of a second conductivity type (i. e. N type) in the substrate 20. An insulating layer 23, typically 500 to 1000 Å of silicon dioxide or the like, overlies the substrate and isolates the gate 14. Openings in the oxide layer 23 (not shown) are provided to make ohmic electrical contacts 21a and 22a to each of the diffused regions 21 and 22 as well as to the gate 14. The formation of such FETs is well known in the art.

The gate 14, normally formed of polysilicon, is directly connected to one end 12a of resistor 12 formed, for example of a thin film of polysilicon laid down on a thicker coating of oxide 23a in a serpentine pattern and designed to have a resistance of 16 kΩ. This resistor 12 has its other end 12b coupled to one end of the second resistor 15. This resistor 15 is also formed of a thin film of polysilicon laid down in a serpentine pattern

BU 981 010

and also is designed to have a resistance of 16 kΩ. The other end of 15b of resistor 15 is connected to a metallic electrode 24 connected to a N-type diffusion 25 which forms the cathode of diode 16. The substrate 20 forms the anode of diode 16. Overlying the resistor 15 is a 0.76 x 0.76 mm$^2$ square metallic pad 13. This pad 13 is isolated from the resistor by a 3000 Å thick oxide layer 23b.

This structure protects the insulated gate 14 of the FET device 11, whenever large positive voltages are applied, by preventing breakdown of the gate oxide 23 by limiting the voltage on the gate electrode 14. The diode 16 may be a gated diode as shown in Fig. 3. An isolated gate 26 partially overlapping the diffusion 25 can be selectively biased to selectively control the diode characteristics as is known to the art. Also a P+ diffusion 27 may be used to provide a good nearby substrate contact for electrode 28 which is coupled to ground via bus 29 thus effectively eliminating unwanted internal resistance between the diode 16 and ground.

As shown in Fig. 4, this protective circuit, when in integrated form as set out in Fig. 3, permits the application of positive forward voltages of at least 20 V to be applied to the pad 13 before any significant current flow is observed. Even if the voltage is extended to 25 V, only a modest 200 μA of current flow is observed. When negative voltages are applied to the pad 13, the diode is forward biased and immediately begins to draw current. However, this current flow through the protective diode 16 is limited by the resistor 15 and is restricted to a moderate amount, i. e. 400 μA at 10 V. Thus, the circuit permits both positive and negative voltage excursions to be applied to the gate of the FET 11 substantially in

BU 981 010

excess of the voltage levels that cause diode conduction and thereby provides protection against both positive and negative voltages applied to the gate electrode.

The described arrangement can be produced in both P and N channel technologies.

BU 981 010

## P A T E N T   C L A I M S

1.  An input overvoltage protection circuit (10) for
    integrated circuits, in particular MIS circuits,
    comprising:

    a signal input chip pad (13) coupled to the integrated circuit input terminal, in particular to
    the gate (14) of the MIS circuit to be protected,

    a series circuit comprising a thin film current-
    limiting resistor (15) and a diode (16), and

    means coupling said series circuit between the input pad and a source of reference potential.

2.  The circuit of claim 1, wherein said chip pad (13)
    is coupled to said input terminal or gate (14) via
    a second thin film resistor (12).

3.  The circuit of claim 2, wherein said diode (16) is
    a gated diode whose characteristics can be controlled by biasing said input terminal or gate (14).

4.  The circuit of claim 2, wherein said series circuit
    (45, 16) clamps said input pad (13) at a voltage
    below the gate breakdown voltage of said integrated
    circuit, in particular said MIS circuit.

5.  An overvoltage protection circuit for a semiconductor device (11) having an insulated gate electrode
    (14) comprising;

    a semiconductor substrate (20) of a first conductivity type having a main surface,

a first (21), a second (22) and a third (25) semiconductor region of a second conductivity type
formed separately in the surface of said substrate,

an insulating film (23) covering the surface of
said substrate,

a gate electrode (14) formed on said insulating
film,

a source and a drain electrode (21a, 22a) provided
on the surface of said first and second regions,
respectively,

a first electrode (24) provided separately on the
surface of said third region,

first and second resistors (12, 15) having a
junction therebetween formed on said insulating
film and serially connecting said first electrode
and said gate electrode,

an input signal pad (13) coupled to said junction,

said third region forming a diode (16) with said
substrate for clamping said input signal pad at a
voltage lower than the breakdown voltage of the
insulating film.

6.  The circuit of claim 5, wherein each of said resistors (12, 15) comprises a serpentine polysilicon
path.

7.  The circuit of claim 6, wherein an insulating layer
(23b) overlies said resistors (12, 15) and said pad (13) overlies one (15) of said resistors and is connected to both of them.

8. The circuit of claim 6, wherein said third region (25) forms the anode and said substrate (20) forms the cathode of said diode (16).

9. The circuit of claim 7, wherein the first (12) of said resistors is coupled between said pad (13) and said gate (14) and the second (15) of said resistors is coupled between said pad and said third region (25).

10. The circuit of claim 9, wherein said first resistor (12) has a value such that the RC time constant of the resistor and the capacitance of the gate (14) is long enough to assure full static discharge of the gate through the second resistor and the diode (16) when positive voltages are applied to said pad (13).

BU 981 010

**FIG. 1**

**FIG. 4**

**FIG. 3**

FIG.2